(19) Europäisches Patentamt / European Patent Office / Office européen des brevets

(11) **EP 1 811 561 A1**

(12) **DEMANDE DE BREVET EUROPEEN**

(43) Date de publication:
**25.07.2007 Bulletin 2007/30**

(51) Int Cl.:
***H01L 21/762*** *(2006.01)*

(21) Numéro de dépôt: **07100879.1**

(22) Date de dépôt: **22.01.2007**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **23.01.2006 FR 0600594**

(71) Demandeur: **S.O.I.Tec Silicon on Insulator Technologies**
**38190 Bernin (FR)**

(72) Inventeurs:
• **Allibert, Frédéric**
  **38100 Grenoble (FR)**
• **Kerdiles, Sébastien**
  **38330 Saint-Ismier (FR)**

(74) Mandataire: **Bomer, Françoise Marie et al**
**Cabinet Régimbeau**
**Espace Performance**
**Bâtiment K**
**35769 Saint-Gregoire-Cedex (FR)**

(54) **Procédé de fabrication d'un substrat composite**

(57)    L'invention concerne un procédé de fabrication d'un substrat composite (4), du type comprenant au moins une couche finale mince d'isolant (3), intercalée entre un substrat support (1) et une couche active (20) de matériaux semiconducteurs.

Il est remarquable en ce qu'il comprend les étapes de :
- formation ou dépôt d'une couche d'isolant (31) sur ledit substrat support (1) et d'une couche d'isolant (32) sur un substrat source (2),
- activation par plasma d'au moins l'une desdites couches d'isolant,
- collage des deux substrats (1, 2) par adhésion moléculaire, par leurs couches d'isolant respectives,
- retrait d'une partie arrière (21) du substrat source (2), de façon à ne conserver que ladite couche active (20),

la valeur de l'énergie d'activation par plasma et les épaisseurs respectives ($e_1$, $e_2$) des couches d'isolant (31, 32) étant choisies, de façon que la couche d'isolant activée ne le soit que dans sa partie supérieure, et l'épaisseur de ladite couche finale d'isolant (3) est inférieure ou égale à 50 nanomètres.

FIG. 2E

EP 1 811 561 A1

## Description

La présente invention concerne un procédé de fabrication d'un substrat composite, du type comprenant une couche d'isolant, enterrée, c'est-à-dire intercalée, entre un substrat support semi-conducteur et une couche active de matériau semi-conducteur.

Dans la suite de la description et des revendications, le terme "isolant" désigne un matériau électriquement isolant, présentant éventuellement une permittivité diélectrique élevée.

Plus précisément, l'invention concerne un procédé permettant d'obtenir un substrat composite tel que précité, dont la couche d'isolant est mince, c'est-à-dire inférieure à 50 nm (50 nanomètres), voire même inférieure à 20 nm (20 nanomètres) et dont les propriétés électriques sont sensiblement améliorées.

Un tel substrat est utilisé en particulier dans les domaines de l'optique, l'électronique et l'optoélectronique.

Un exemple particulier, mais non limitatif, de ce type de substrat composite est un substrat connu sous l'acronyme "SOI", d'après la terminologie anglaise de "silicon on insulator ", qui désigne un substrat comprenant une couche d'oxyde de silicium isolant, intercalée entre deux couches de silicium.

Les propriétés électriques que le procédé conforme à l'invention vise à améliorer sont plus précisément :

- La densité de charges (connue sous l'abréviation "Q box" en anglais) dans la couche enterrée isolante. On cherche à obtenir une valeur inférieure à $5.10^{11}$ charges par $cm^2$.
- La tension de claquage, c'est-à-dire la tension à partir de laquelle la résistivité de l'isolant chute fortement. On cherche à obtenir des valeurs maximales. A titre d'exemple, pour une couche enterrée d'oxyde de silicium, on cherche de préférence à obtenir une valeur la plus proche de 10 MV/cm.
- La mobilité des trous et/ou des électrons dans la couche active. A titre d'exemple illustratif, il serait souhaitable d'obtenir une mobilité électronique supérieure à 500 $cm^2.V^{-1}.s^{-1}$, dans du silicium dopé en bore avec une concentration de l'ordre de $10^{15}at/cm^3$.
- La valeur de "DIT", d'après la terminologie anglaise de "interface trap density", qui désigne la densité de pièges au niveau d'une interface entre deux couches. Dans le cadre de la présente invention, on cherche à améliorer les valeurs de DIT, au niveau des interfaces respectives de la couche d'isolant enterrée, avec les couches voisines.

Dans la suite de la description, on se focalise sur les valeurs de DIT, parce que c'est l'un des principaux paramètres sur lequel les étapes de formation du substrat conformes à l'invention ont une influence. De plus, ce paramètre à une incidence sur la mobilité. Toutefois, l'invention vise bien de manière générale à améliorer les performances électriques du substrat final.

Les pièges ont la capacité de retenir ou de libérer des porteurs de charge au niveau des interfaces. Ils ont un impact extrêmement néfaste sur les propriétés électriques des futurs composants électroniques qui seront réalisés sur le substrat composite.

La densité de pièges au niveau d'une interface, ci-après dénommée à des fins de simplification, la "valeur de DIT", s'exprime en nombre de pièges/$eV.cm^2$. Plus la valeur de DIT est élevée et plus les propriétés électriques du substrat sont mauvaises.

A titre d'exemple, une valeur de $10^{12}$ $eV^{-1}.cm^{-2}$ est une valeur élevée qui correspond à de mauvaises propriétés électriques du substrat. Actuellement, les meilleures valeurs de DIT obtenues sont de l'ordre de $10^{10}$ $.eV^{-1}.cm^{-2}$, pour les interfaces entre des oxydes de très bonne qualité, dits "oxydes de grille" et leur support. On trouve de tels oxydes, par exemple, dans les transistors, les mémoires, les capacités et autres types de composants formant des circuits intégrés.

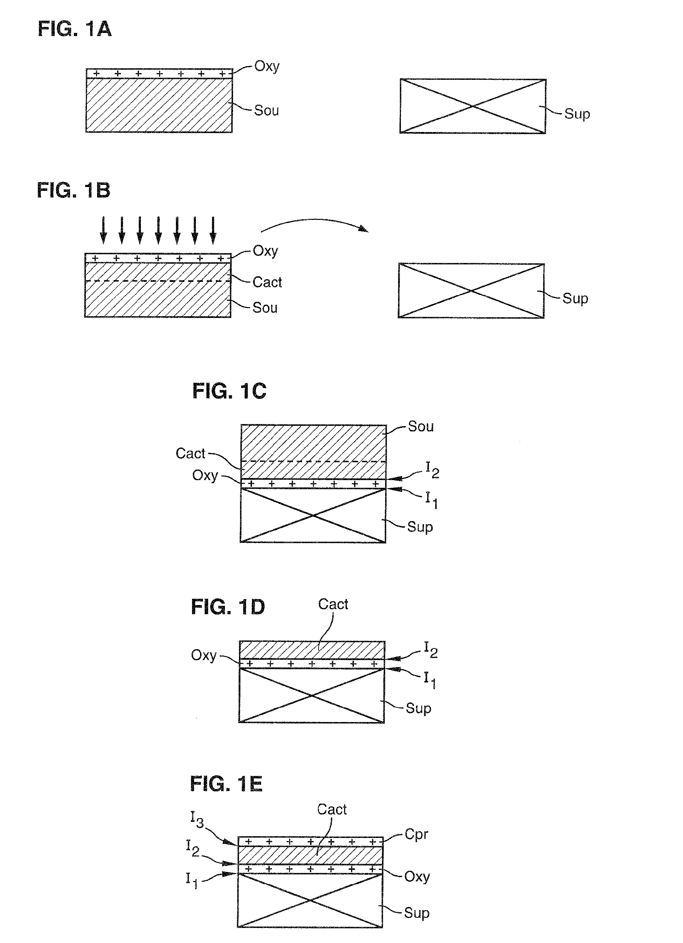

Les figures 1A à 1E jointes illustrent les différentes étapes de l'un des modes de fabrication d'un substrat de type SOI, connu de l'état de la technique.

Comme représenté sur les figures 1A et 1B, ce procédé consiste à oxyder un substrat source **Sou,** de façon à former à sa surface une couche d'oxyde **Oxy,** puis à y effectuer une implantation d'espèces atomiques, de façon à délimiter une couche active **Cact.** La couche d'oxyde est généralement assez épaisse, de l'ordre de 150 nm.

Après collage sur un substrat support **Sup** (figure 1C) et détachement du reste du substrat source **Sou** (figure 1D), on obtient un substrat composite comprenant une couche d'oxyde **Oxy,** intercalée entre un support et une couche active et qui présente avec chacun d'eux, une interface de contact, référencées respectivement $I_1$ et $I_2$.

Enfin, après la fabrication, on peut former sur la surface supérieure du substrat composite ainsi obtenu, une couche destinée à protéger cette surface, lors des traitements thermiques de finition du substrat. Le substrat est ainsi recouvert d'une couche protectrice **Cpr** et il existe une interface $I_3$ entre cette couche protectrice **Cpr** et la couche active **Cact.**

On connaît déjà d'après l'état de la technique, des procédés permettant d'améliorer, c'est-à-dire d'abaisser, les valeurs de DIT, au niveau de certaines interfaces d'un substrat composite. Ce sont principalement des traitements thermiques.

L'un d'entre eux, connu sous l'acronyme "FGA", d'après la terminologie anglaise de "Forming Gas Anneal", consiste à effectuer un traitement thermique de réparation /guérison des interfaces à basse température, de l'ordre de 450°C, dans une atmosphère contenant de l'hydrogène et un gaz neutre.

Toutefois, lorsqu'un tel procédé est réalisé à 450°C, son effet sur l'amélioration de la valeur de DIT s'exerce uniquement sur l'interface $I_3$ entre la couche protectrice **Cpr** et la couche active **Cact** et non sur les interfaces $I_1$ et $I_2$, ou seulement très faiblement. En effet, ce procédé de traitement FGA perd de son efficacité à chaque interface rencontrée. Il est donc relativement inefficace sur les interfaces profondes.

Une autre possibilité consiste à effectuer un traitement thermique de recuit à une haute température, c'est-à-dire supérieure à 900°C, voire supérieure à 1000°C. Un tel traitement permet d'améliorer la valeur de DIT à l'interface $I_2$, mais n'a quasiment pas d'effet sur l'interface $I_1$, située plus profondément.

Par ailleurs, dans de nombreuses applications désormais, on cherche à obtenir une couche d'isolant (oxyde) enterrée fine, par exemple inférieure à 50 nm, voire même à 20 nm.

Dans ce cas, l'oxyde ne joue plus uniquement un rôle d'isolant électrique, mais fait partie intégrante des composants électroniques qui seront formés à la surface du substrat composite.

De plus, le support **Sup,** situé en dessous, n'a plus uniquement une fonction mécanique, mais également électrique. Ce substrat support **Sup** peut éventuellement contenir des structures enterrées, par exemple un plan de masse ("ground plane" en anglais) ou être composite.

En conséquence, il est souhaitable que les valeurs de DIT soient améliorées au niveau des deux interfaces $I_1$ et $I_2$, situées de part et d'autre de la couche d'isolant enterrée.

Toutefois, il est bien connu que l'obtention de substrats composites comportant une couche d'isolant enterrée très fine est délicate. Ainsi, par exemple, pour un substrat de type SOI, on sait que plus la couche d'oxyde est fine et plus le nombre de défauts à l'intérieur du substrat final est important. Ceci est dû principalement à la présence de contaminants, de particules polluantes et de gaz, encapsulés lors du collage au niveau de l'interface $I_1$.

Pour améliorer ce collage, une solution consiste à effectuer une activation par plasma d'au moins l'une des surfaces à coller, à savoir celle du support **Sup** et/ou de l'isolant **Oxy.** On obtient alors une énergie de collage élevée, voisine d'1 J/m$^2$, à l'interface $I_1$, et ce, même après un recuit à 200°C pendant 2 heures uniquement.

Cependant, l'activation par plasma a pour effet de détériorer de manière assez significative, les caractéristiques électriques de l'interface $I_1$ et notamment ses valeurs de DIT.

On pourra se reporter à ce sujet à l'article de K. Schjölberg-Henriksen et al., "Oxide charges induced by plasma activation for wafer bonding", Sensors and Actuators A 102 (2002) 99-105, qui montre l'effet négatif de l'activation par plasma sur les propriétés électriques des substrats.

L'invention a pour but de résoudre les inconvénients précités de l'état de la technique.

Elle a plus précisément pour but de mettre au point un procédé d'obtention d'un substrat composite, avec une couche d'isolant enterrée mince, c'est-à-dire inférieure à 50 nm, voire même inférieure à 20 nm et pouvant même atteindre 5 nm, et qui présente de bonnes propriétés électriques, c'est-à-dire dont les valeurs de DIT aux deux interfaces de cette couche d'isolant sont faibles.

A cet effet, l'invention concerne un procédé de fabrication d'un substrat composite, du type comprenant au moins une couche mince d'isolant, dite "couche finale", intercalée entre un premier substrat semi-conducteur, dit "substrat support" et une couche de matériau semi-conducteur, dite "couche active", caractérisé en ce qu'il comprend les étapes de :

- formation ou dépôt d'une couche d'isolant, dite "première couche", sur ledit substrat support et d'une couche d'isolant, dite "seconde couche", sur un second substrat, dit "substrat source",
- activation par plasma d'au moins l'une desdites première et seconde couches d'isolant,
- collage dudit substrat support et dudit substrat source l'un contre l'autre, par adhésion moléculaire, de façon que lesdites première et seconde couches d'isolant soient en contact, le long d'une interface de collage, et forment ensemble ladite couche finale d'isolant,
- retrait d'une partie, dite "arrière" du substrat source, de façon à ne conserver qu'une épaisseur de matériau constituant ladite couche active,

la valeur de l'énergie d'activation par plasma et les épaisseurs respectives **($e_1$, $e_2$)** de la première et de la seconde couches d'isolant étant choisies, de façon que la couche d'isolant activée, ne le soit que dans sa partie supérieure, s'étendant depuis sa surface libre, et l'épaisseur de ladite couche finale d'isolant est inférieure ou égale à 50 nanomètres (50 nm), de préférence inférieure ou égale à 20 nanomètres (20 nm).

Selon d'autres caractéristiques avantageuses et non limitatives de l'invention, prises seules ou en combinaison :

- l'épaisseur ($e_1$) de la première couche d'isolant formée ou déposée sur le substrat support et l'épaisseur ($e_2$) de la seconde couche d'isolant formée ou déposée sur le substrat source satisfont aux relations suivantes :

$$e_1 \geq e_{mp1} + d_1 \quad \text{et} \quad e_2 \geq e_{mp2} + d_2$$

dans lesquelles $e_{mp1}$ et $e_{mp2}$ correspondent respectivement à l'épaisseur de la première couche d'isolant et à l'épaisseur de la seconde couche d'isolant dont la nature est modifiée après le traitement par activation par plasma

et $d_1$ et $d_2$ correspondent aux distances tunnel respectives de la première et de la seconde couches d'isolant.

- les première et seconde couches d'isolant ont des valeurs de densité de pièges d'interface (DIT) inférieures ou égales à $10^{11}$ eV$^{-1}$.cm$^{-2}$, de préférence inférieures ou égales à quelques $10^{10}$.eV$^{-1}$.cm$^{-2}$, à leurs interfaces respectives avec les couches sur lesquelles elles sont déposées ou formées, lorsque ces dernières sont en silicium et que les couches d'isolant sont en dioxyde de silicium (SiO$_2$);
- 1 a première couche d'isolant ou/et la seconde couche d'isolant est/sont un oxyde ou un matériau diélectrique à forte permittivité ;
- l'activation par plasma consiste à soumettre la première et/ou la seconde couche(s) d'isolant à un plasma oxygène avec un débit compris entre 50 et 200 sccm, une pression à l'intérieur de l'enceinte de 50 mTorr, une puissance de plasma d'environ 250 W pour des substrats de 200 mm et d'environ 500 W pour des substrats de 300 mm, pendant une durée comprise entre 5 et 60 secondes.

Le procédé peut en outre comprendre une étape de recuit sous un mélange de gaz neutre et d'hydrogène, à une température voisine de 900°C, pendant une durée d'au moins deux heures, d'au moins l'un des deux substrats recouvert de sa couche d'isolant, cette étape étant réalisée avant l'activation par plasma.

De façon avantageuse, le retrait de la partie arrière du substrat source est effectué par meulage et/ou polissage.

Le procédé peut également comprendre la formation d'une zone de fragilisation à l'intérieur du substrat source, effectuée avant l'étape d'activation par plasma et le retrait de la partie arrière du substrat source, par détachement le long de cette zone de fragilisation.

De façon avantageuse, la formation de cette zone de fragilisation s'effectue par implantation d'espèces atomiques à l'intérieur du substrat source. Dans ce dernier cas, si l'étape de recuit précitée est effectuée, elle l'est avant l'étape d'implantation.

L'invention trouve une application particulière dans la fabrication d'un substrat SOI, dans lequel le substrat source est en silicium et la première et la seconde couches d'isolant en oxyde de silicium.

L'invention concerne également un substrat composite qui comprend au moins une couche d'isolant, intercalée entre un premier substrat semi-conducteur, dit "substrat support" et une couche de matériau semi-conducteur, dite "couche active", cette ou ces couche (s) d'isolant formant une couche d'isolant dite "finale", ayant une épaisseur totale inférieure ou égale à 50 nanomètres (50 nm), de préférence inférieure ou égale à 20 nanomètres, et présentant des valeurs de densité de pièges d'interface (DIT) inférieures ou égales à $10^{11}$.eV$^{-1}$.cm$^{-2}$ à son interface avec ledit substrat support et à son interface avec ladite couche active, de préférence encore inférieures ou égales à quelques $10^{10}$.eV$^{-1}$.cm$^{-2}$.

D'autres caractéristiques et avantages de l'invention apparaîtront de la description qui va maintenant en être faite, en référence aux dessins annexés, qui en représentent, à titre indicatif mais non limitatif, un mode de réalisation possible et ses variantes.

Sur ces dessins :

- les figures 1A à 1E sont des schémas représentant les différentes étapes de fabrication d'un substrat de type SOI, conformément à un mode de réalisation connu de l'état de la technique,
- les figures 2A à 2E sont des schémas représentant les différentes étapes du procédé de fabrication, conformes à un premier mode de réalisation de l'invention,
- les figures 3A à 3E sont des schémas représentant une variante de réalisation du procédé illustrés sur les figures 2A à 2E,
- la figure 4 est un graphique représentant l'épaisseur $e_{ap}$ de la couche d'isolant qui se trouve modifiée après traitement par activation par plasma, en fonction de la densité de puissance $D_P$ appliquée pour générer ce plasma, et ce, pour deux types de substrats de diamètres différents, et
- la figure 5 est une vue agrandie des figures 2E et 3E, sur laquelle les distances dites "tunnel" ont été représentées.

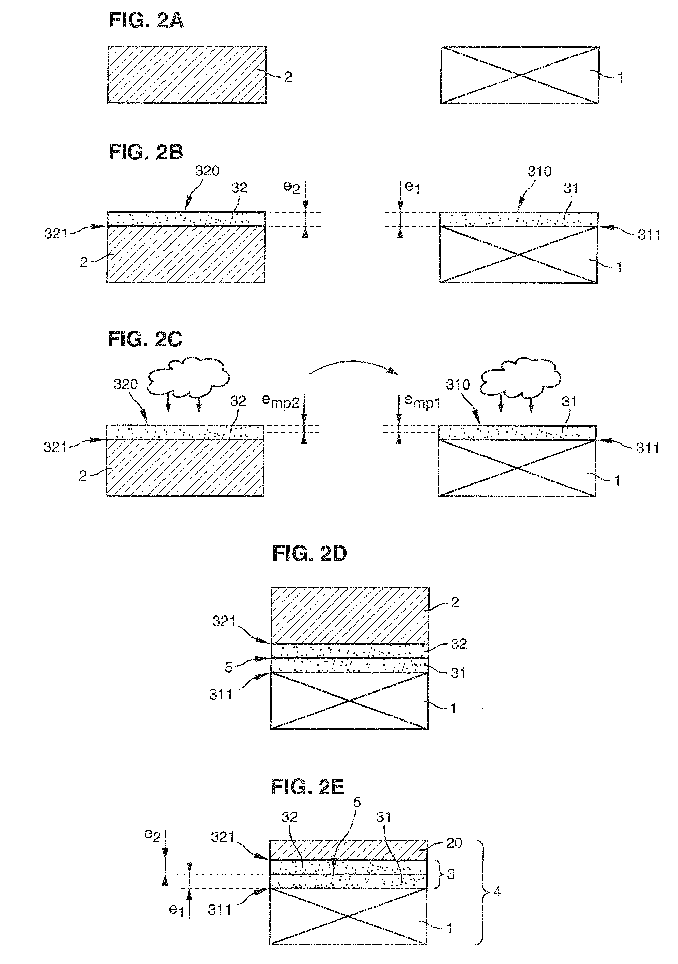

En se reportant à la figure 2A, on peut voir que le procédé conforme à l'invention utilise un premier substrat 1, dit "substrat support" et un second substrat 2, dit "substrat source".

Comme représenté sur la figure 2B, on forme ou l'on dépose ensuite une couche d'isolant 31, dite "première couche d'isolant" sur le substrat support 1 et une couche d'isolant 32, dite "seconde couche d'isolant" sur le substrat source 2.

L'interface entre la couche d'isolant 31 et le substrat support 1 porte la référence 311 et celle entre les couches 32 et 2, la référence 321.

Les surfaces libres des couches d'isolant 31, 32 portent respectivement les références numériques 310 et 320.

Comme cela apparaît mieux sur la figure 2C, on procède ensuite à l'activation par plasma d'au moins l'une des deux couches d'isolant 31, 32.

On procède ensuite à la préparation des surfaces 310 et 320, en vue de leur collage, effectué par adhésion moléculaire (voir figure 2D).

L'interface de collage porte la référence numérique 5.

Enfin, on procède au retrait d'une partie, dite "arrière" du substrat source 2, de façon à ne conserver qu'une épaisseur de ce matériau, qui constitue une couche active 20, dans le substrat composite final référencé 4, (voir figure 2E).

Dans ce substrat composite 4, le substrat 1 joue un rôle de support mécanique, comme c'est le cas habituellement dans l'état de la technique.

De plus, le substrat support 1 fait également partie intégrante des composants électroniques qui seront fabriqués ultérieurement à la surface du substrat composite 4. Dans le cadre de l'invention, où l'on cherche notamment à obtenir un matériau présentant une faible valeur de DIT à l'interface 311 entre l'isolant 31 et le substrat support 1, la nature et les caractéristiques physiques du matériau constituant ce substrat support 1 ont une influence sur les performances électriques desdits composants électroniques. De ce fait, le substrat support 1 est avantageusement réalisé en matériau semi-conducteur.

De plus, il est même possible que ce substrat support 1 contienne des éléments qui seront constitutifs des composants électroniques finaux (comme par exemple des électrodes, un plan de masse, un canal...).

Enfin, il est également possible d'avoir comme substrat support 1, un substrat composite, de manière à réaliser une structure multicouches. A titre d'exemple purement illustratif, un substrat massif de silicium avec une couche épitaxiée de silicium germanium (SiGe) contenant 20% de germanium peut servir de substrat support.

La couche active 20 du substrat composite 4 est issue du substrat source 2, comme cela sera décrit ultérieurement. Ce substrat source 2 est également en matériau semi-conducteur.

A titre d'exemple purement illustratif, on citera ci-après différents exemples de matériaux susceptibles d'être utilisés comme substrats 1 et 2 :

- sub strat support 1 : silicium (Si), carbure de silicium (SiC), germanium (Ge), couche épitaxiée quelconque, par exemple une couche de germanium (Ge), de silicium germanium (SiGe), ou de nitrure de gallium (GaN) sur un substrat de silicium, voire même une couche de silicium contraint.
- subs trat source 2 : silicium (Si), germanium (Ge), carbure de silicium (SiC), nitrure de gallium (GaN), silicium germanium (SiGe), arséniure de gallium (AsGa) ou phosphure d'indium (InP).

Les couches d'isolant 31, 32 sont choisies, par exemple, parmi des couches d'oxyde ou de nitrure, telles que de l'oxyde de silicium ($SiO_2$) ou du nitrure de silicium ($Si_3N_4$) ; de l'oxynitrure de germanium ($Ge_xO_yN_z$) ; des matériaux diélectriques à forte permittivité (« high k » selon la terminologie anglaise), tels que par exemple, du dioxyde de hafnium ($HfO_2$), de l'oxyde d'yttrium ($Y_2O_3$), du trioxyde de strontium et de titane ($SrTiO_3$), de l'alumine ($Al_2O_3$), du dioxyde de zirconium ($ZrO_2$), du pentoxyde de tantale ($Ta_2O_5$), du dioxyde de titane ($TiO_2$), leurs nitrures et leurs siliciures.

La nature de chaque couche d'isolant 31 ou 32 sera choisie d'une part, de manière à optimiser les performances électriques des interfaces 311 et 321, et d'autre part, en fonction de la nature des matériaux utilisés pour le substrat support 1 et le substrat source 2. A titre d'exemple, pour réaliser un substrat final 4 du type GeOI (germanium sur isolant), on pourra former une couche fine d'oxyde de silicium sur le substrat support en silicium et une couche de $HfO_2$ sur le substrat source en germanium.

De préférence, les isolants 31, 32 sont d'excellente qualité, en ce qui concerne leurs propriétés électriques. Plus précisément, ils présentent des valeurs de DIT au niveau des interfaces 311 et 321 les plus faibles possibles.

A titre d'exemple illustratif, lorsque les couches 1 et 2 sont en silicium et que les couches d'isolant 31, 32 sont en dioxyde de silicium, les valeurs de DIT au niveau des interfaces 311 et 321 sont inférieures ou égales à $10^{11}$ .$eV^{-1}$.$cm^{-2}$, voire même inférieures ou égales à quelques $10^{10}$ .$eV^{-1}$.$cm^{-2}$.

Ainsi, lorsque l'isolant est un oxyde, il est formé avec toutes les précautions prises pour former les oxydes de qualité optimale, comme par exemple les oxydes de grille. On pourra se référer, à ce sujet, à l'article de Green et al. "Ultrathin (<4nm) SiO2 and Si-O-N gate dielectric layers for silicon microelectronics: Understanding the processing, structure, and physical and electrical limits ", Journal of Applied Physics, volume 90, n°5, 1 septembre 2001, pages 2086 et suivantes.

Les surfaces des substrats 1 et 2, sur lesquelles l'oxyde sera formé, sont préparées par un nettoyage approfondi, par exemple à l'aide d'un traitement dans un bain chimique dénommé "RCA", afin d'éviter toute contamination.

Le traitement "RCA" consiste à traiter les surfaces, successivement avec :

- un premier bain d'une solution connue sous l'acronyme "SC1" (d'après la terminologie anglo-saxonne de "Standard Clean 1" qui signifie "solution de nettoyage standard 1"), et qui comprend un mélange d'hydroxyde d'ammonium ($NH_4OH$), de peroxyde d'hydrogène ($H_2O_2$) et d'eau déionisée,
- un second bain d'une solution connue sous l'acronyme "SC2" (d'après la terminologie anglo-saxonne de "Standard Clean 2" qui signifie "solution de nettoyage standard 2"), et qui comprend un mélange d'acide chlorhydrique (HCl), de peroxyde d'hydrogène ($H_2O_2$) et d'eau déionisée.

Les oxydes sont ensuite obtenus par un traitement thermique d'oxydation, respectivement du substrat support 1 et/ou du substrat source 2, éventuellement suivi d'un traitement de post-oxydation, du type « Forming Gas Anneal » (FGA).

Les couches d'isolants 31, 32 peuvent également être obtenues par dépôt chimique en phase vapeur à basse pression (LPCVD), ou par un procédé de dépôt de couches atomiques, connu sous l'acronyme ALD ("atomic layer deposition" en anglais).

Ce dépôt peut éventuellement être précédé d'un traitement de passivation de surface des substrats 1 ou 2. A titre d'exemple, ce traitement peut consister à former quelques monocouches de dioxyde de silicium ($SiO_2$) sur du silicium avant le dépôt d'une couche d'isolant 31 ou 32 en dioxyde de hafnium ($HfO_2$).

Les caractéristiques concernant les épaisseurs $e_1$ et $e_2$ des couches d'isolant 31, 32 seront décrites ultérieurement.

Le traitement d'activation plasma (figure 2C) est effectué dans des conditions qui préservent les caractéristiques électriques et notamment les valeurs de DIT de l'interface entre la couche d'isolant et la couche voisine.

L'"activation plasma" d'une surface se définit comme l'exposition de cette surface à un plasma, ceci pouvant se faire notamment dans une enceinte sous vide ou à pression atmosphérique.

Cette activation est réalisée en contrôlant divers paramètres d'exposition, tels que la nature, le débit ou la pression du gaz alimentant l'enceinte à l'intérieur de laquelle est réalisée l'activation, ainsi que la puissance appliquée.

Dans le cadre de l'invention, le substrat recouvert de la couche d'isolant à activer est introduit dans l'enceinte, puis on envoie à l'intérieur de celle-ci, un gaz pur, typiquement de l'oxygène ($O_2$), éventuellement de l'azote ($N_2$), de l'argon (Ar) ou de l'hélium (He) ou encore un mélange de ces gaz, tel que oxygène et hélium, oxygène et argon ou hélium et azote, par exemple.

Le débit du gaz utilisé est fonction du volume de l'enceinte d'activation et de la taille du substrat.

De préférence, le gaz est envoyé avec un débit compris entre 10 et 1000 sccm (centimètre cube standard par minute, d'après la terminologie anglaise de *"standard cubic centimeter per minute"*), typiquement entre 50 et 200 sccm. A titre d'exemple, on utilise typiquement un débit de 75 sccm pour un substrat de 200 mm de diamètre et de 200 sccm pour un substrat de 300 mm de diamètre.

La pression régnant dans l'enceinte lors du traitement plasma est contrôlée, pour se situer dans la gamme de 10 à 200 mTorr, typiquement voisine de 50 mTorr, (1 mTorr étant égal à $1{,}33.10^{-1}$ Pa).

Le plasma est initié puis entretenu par l'application d'un puissance RF (radiofréquence) comprise entre 100 et 2000 W, de préférence voisine de 250 W dans le cas de substrats de 200 mm de diamètre et comprise entre 100 et 3000 W, de préférence voisine de 500 W dans le cas de substrats de 300 mm de diamètre.

La surface de l'isolant est alors exposée au plasma pendant 5 à 60 secondes, de préférence 10 à 30 secondes.

Lors du traitement par plasma, les surfaces 310 et/ou 320 des isolants sont notamment soumises à un bombardement ionique qui modifie l'isolant traité sur une épaisseur $e_{mp}$ (épaisseur modifiée par le traitement par plasma).

Ces épaisseurs, référencées $e_{mp1}$ ou $e_{mp2}$, suivant qu'elles concernent la première couche d'isolant 31 ou la seconde 32, peuvent être contrôlées, en fonction de la puissance utilisée pour appliquer le plasma et de la durée d'exposition à ce plasma.

Chaque couche d'isolant 31, 32 est ainsi modifiée uniquement dans sa partie supérieure, c'est-à-dire par référence aux figures, la partie qui s'étend depuis sa surface libre 310, respectivement 320.

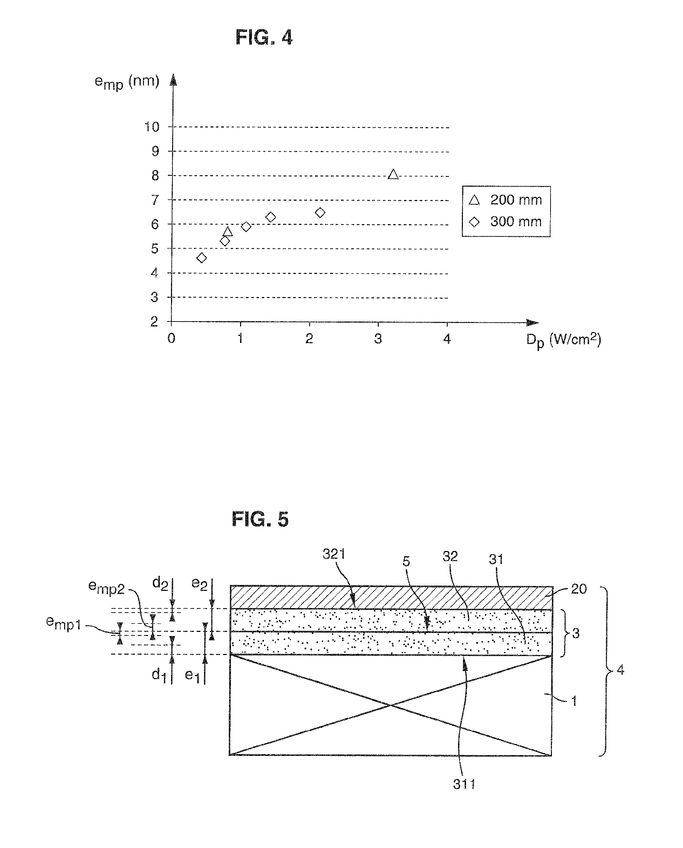

Des mesures ont été effectuées pour déterminer l'épaisseur $e_{mp}$ de la couche d'isolant qui se trouve modifiée par le traitement par plasma, en fonction de la densité $D_P$ de la puissance du plasma appliqué, exprime en $W/cm^2$, pendant une durée de 30 secondes. Ces mesures ont été effectuées sur une couche d'oxyde de silicium, le plasma étant un plasma d'oxygène. Les résultats obtenus sont reportés sur la figure 4 jointe.

Les résultats représentés à l'aide d'un triangle correspondent à ceux obtenus avec des substrats d'un diamètre de 200 mm et ceux représentés à l'aide de losanges, à ceux obtenus pour des substrats de 300 mm de diamètre.

Ces résultats montrent que le traitement par plasma peut conduire à modifier la nature de la couche d'oxyde sur une épaisseur de 8 nm. Des mesures complémentaires ont montré que cette épaisseur pouvait être plus importante, par exemple pour une densité de puissance plus importante.

En conséquence, pour éviter que le traitement par plasma n'affecte les valeurs de DIT des interfaces 311, 321, il est nécessaire de former une couche d'isolant dont l'épaisseur $e_1$ ou $e_2$ est supérieure aux épaisseurs respectives $e_{mp1}$ et $e_{mp2}$ modifiées par le plasma.

Ainsi, de préférence, les épaisseurs $e_1$ et $e_2$ des couches d'isolant 31, 32 satisfont aux relations suivantes :

$$e_1 \geq e_{mp1} + d_1$$

$$e_2 \geq e_{mp2} + d_2$$

dans lesquelles $d_1$ et $d_2$ représentent respectivement les distance s "tunnel" de la première et de la seconde couche d'isolant 31, 32.

Chaque isolant est ainsi plus épais que la partie susceptible d'être perturbée par le traitement par plasma, en prenant au moins la distance tunnel comme épaisseur de sécurité.

Dans la suite de la description et des revendications, la distance tunnel $d_1$ (respectivement $d_2$) se définit comme étant la distance prise depuis l'interface 311, respectivement 321, au-delà de laquelle les pièges ou les défauts créés par le plasma ne sont plus susceptibles d'être chargés, par effet "tunnel", lorsque le composant électronique, fabriqué à partir du substrat composite 4, est utilisé.

Les distances tunnel $d_1$ et $d_2$ sont représentées sur la vue agrandie de la figure 5.

En d'autres termes, les défauts créés sont suffisamment loin de l'interface 311 ou 321 pour ne pas avoir d'influence significative sur celle-ci. La distance tunnel $d_1$ ou $d_2$ dépend de la nature des matériaux constituant l'isolant, les substrats source et support, et dépend également des types de composants électroniques réalisés (car la distance tunnel dépend du champ électrique autour de l'interface).

L'homme du métier saura déterminer la valeur de $d_1$ et $d_2$ suivant les valeurs de ces paramètres. A titre d'exemple, la distance tunnel vaut approximativement 2 nm pour un oxyde de Si ($SiO_2$) sur du silicium, dans la gamme de tension utilisée en technologie CMOS.

De plus, l'épaisseur $e_1$ de la première couche d'isolant 31 et l'épaisseur $e_2$ de la seconde couche d'isolant 32 sont déterminées, de façon que l'épaisseur totale de la couche finale d'isolant 3 du substrat composite 4, n'excède pas de préférence 50 nm, ou mieux encore 20 nm. L'épaisseur de cette couche finale 3 correspond approximativement à la somme de $e_1$ et $e_2$. Toutefois, on notera qu'il est également possible d'amincir légèrement l'une ou l'autre ou les deux couches d'isolant 31, 32, après le traitement par plasma et avant le collage. Cette étape d'amincissement sera décrite ultérieurement.

Enfin, lorsqu'on utilise comme couche d'isolant, un matériau à forte permittivité diélectrique, c'est-à-dire un matériau dont la permittivité relative εr est significativement plus élevée que celle de $SiO_2$ (dont εr est voisin de 3,9), il est courant de convertir son épaisseur e en « épaisseur équivalente d'oxyde » (de l'anglais *« Equivalent Oxide Thickness »*, "EOT"), à l'aide de la formule :

$$EOT = (\varepsilon_{Si02} / \varepsilon r) \cdot e$$

L'invention s'appliquant à la formation d'une couche d'isolant 3 mince (<50 nm) quelque soit sa nature, on comprend alors que si cette couche d'isolant est formée d'une couche à forte permittivité diélectrique, cela permettra d'atteindre une EOT très faible.

Il convient également de limiter au strict nécessaire la durée d'exposition au traitement par plasma.

De préférence, celle-ci est inférieure à une minute, ou mieux encore inférieure à 30 secondes. Une exposition prolongée risquerait d'occasionner une accumulation de charges électriques dans l'isolant et une augmentation de la densité de charge de l'isolant (QBOX en anglais), ce qui va à l'encontre de l'amélioration des performances électriques exposées dans l'introduction.

La gestion respective des paramètres du traitement d'activation par plasma et des épaisseurs des deux couches d'isolant 31 et 32 permet de garantir que les défauts créés par le traitement par plasma seront éloignés des interfaces 311, respectivement 321.

Dans le mode de réalisation illustré sur les figures 2D et 2E, le retrait de la partie arrière du substrat source 2 s'effectue par meulage et/ou polissage.

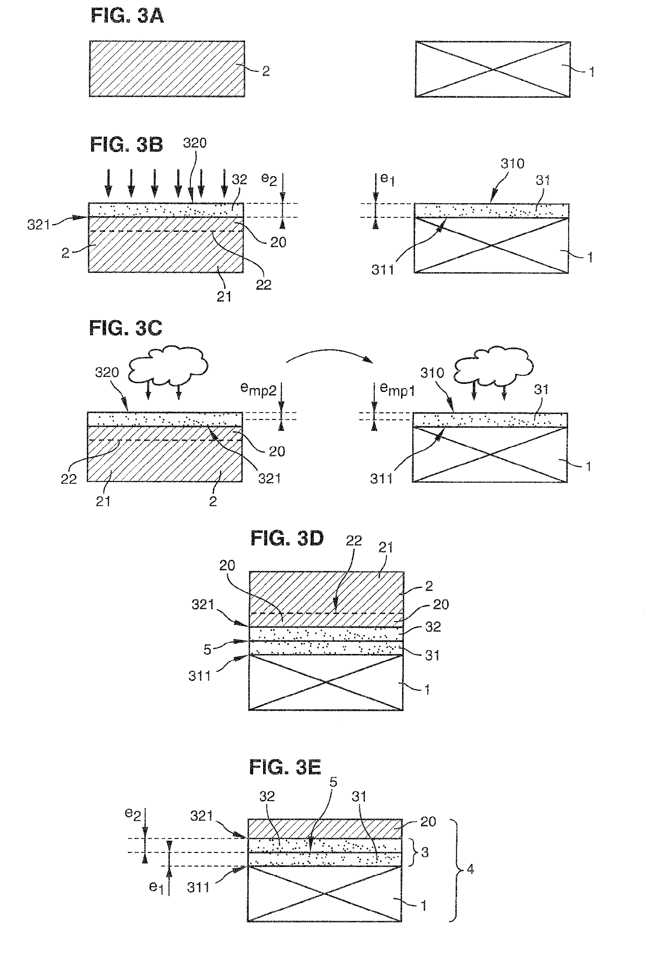

Une variante de réalisation de ce procédé va maintenant être décrite en faisant référence aux figures 3A à 3E. Seules les étapes modifiées qui concernent le retrait de la partie arrière, seront décrites en détail.

Comme on peut le voir sur la figure 3B, on procède à la formation d'une zone de fragilisation 22, à l'intérieur du substrat source 2. Ladite zone de fragilisation délimite la couche active 20 de la partie arrière 21 du substrat 2.

La zone 22 peut être formée par une zone poreuse, voir à ce sujet l'article de K. Sakaguchi et al., "Eltran® by splitting porous Si layers", the ElectroChemical Society, Inc PV99-3, Silicon-on-insulator technology and devices, P.L.Hemment, pp 117-121. Dans ce cas la zone poreuse est formée avant le dépôt de la couche 32.

La zone 22 est toutefois avantageusement formée par implantation d'espèces atomiques légères, de préférence des ions hydrogène et/ou d'hélium, afin de ne pas détériorer l'oxyde mince 32.

Pour les modalités de l'implantation, on pourra se référer à l'article de C. Maleville et C. Mazuré, "Smart Cut™ technology: from 300 nm ultrathin SOI production to advanced engineered substrat es", Solid-State Electronics 48 (2004) 1055-1063.

On notera que bien que cela ne soit pas représenté sur les figures, il est également possible d'effectuer l'étape d'implantation d'espèces atomiques, en ayant pris soin de déposer ou de former sur la couche d'isolant 32, une couche protectrice d'oxyde ou de nitrure.

La nature de cette couche protectrice additionnelle est choisie de manière à faciliter son retrait sélectif, sans abîmer la couche isolante sous-jacente. Ce retrait peut être effectué, par exemple, par gravure sélective.

A titre d'exemple, si l'isolant formé est du $SiO_2$, on pourra déposer une couche protectrice de nitrure de silicium ($Si_3N_4$). Cette couche protectrice sera éliminée ultérieurement, avant l'étape de collage.

Si cette couche protectrice est conservée pendant l'activation par plasma, il faudra tenir compte de son épaisseur pour choisir la puissance du plasma adéquate.

Cette puissance pourra être choisie plus importante, tout en respectant la distance tunnel, cette puissance plus forte pouvant dans certains cas permettre d'obtenir un collage de plus forte énergie.

On procède ensuite aux étapes d'activation par plasma et de collage comme décrit précédemment, (voir figures 3C, 3D).

Avant d'effectuer le traitement plasma, on prendra des précautions de nettoyage spécifiques, afin de s'assurer de l'élimination de particules et de contaminants métalliques, susceptible de générer des défauts, par exemple des charges dans l'isolant (QBOX). Pour nettoyer des surfaces de $SiO_2$, on utilisera, comme décrit précédemment, une solution "RCA", cette solution comprenant une étape de nettoyage à l'aide d'une solution SC2 (qui est connu pour éliminer ces contaminants).

Enfin, comme représenté sur la figure 3E, l'étape de détachement de la partie arrière 21 le long de la zone 22 consiste en l'application de contraintes d'origine thermique ou mécanique, par exemple un traitement de recuit ou l'introduction d'une lame au niveau de ladite zone de fragilisation 22.

Selon une variante des deux modes de réalisation précités, décrits en faisant référence aux figures 2 et 3, en particulier si l'on souhaite réaliser une couche isolante très mince (de l'ordre de 5 nm), on pourra amincir la ou les couches d'isolant 31, 32 après le traitement plasma et avant le collage.

On prendra soin de ne pas procéder au retrait d'une épaisseur au delà de laquelle, on perdrait l'effet de « collage fort » du plasma. Ainsi, on sait qu'au delà d'un amincissement de 5 à 10 angströms d'une couche de $SiO_2$ activée par plasma, cet effet commence à disparaître. Il disparaît totalement pour un amincissement au-delà de 40 angströms. Dans le cas du $SiO_2$, une solution SC1 peut être utilisée pour graver et éliminer une épaisseur choisie de l'oxyde. Cette étape à base de SC1, permet de combiner les effets de nettoyage et de gravure de cette solution.

Selon une autre variante de réalisation des deux procédés précités, décrits en liaison avec les figures 2 et 3, il est également possible d'effectuer, après la formation des couches d'isolant 31, 32 et avant l'étape d'activation par plasma et avant l'implantation éventuelle d'espèces atomiques, un traitement thermique de type "FGA", c'est-à-dire "Forming Gas Anneal".

Ce traitement thermique "FGA" est avantageusement effectué sous une atmosphère de gaz neutre et d'hydrogène, à une température voisine de 450° C, pendant une durée comprise entre environ 30 minutes et quelques heures.

On peut également effectuer un traitement thermique dans un gaz neutre à plus haute température, par exemple supérieure à 900°C pour du $SiO_2$, dans de l'argon.

Ces traitements thermiques peuvent être effectués sur l'un ou l'autre ou les deux substrats 1 et 2.

Le procédé conforme à l'invention présente l'avantage de réaliser l'interface de collage 5 à une distance suffisamment importante des deux interfaces 311 et 321, qui conservent ainsi des valeurs de densité de piège d'interface (DIT) faibles.

Conformément à l'invention, il est également important de former une couche d'isolant 31, 32 sur chacun des substrats 1, 2 à coller, car sinon l'interface de collage qui existerait alors entre l'isolant et le substrat non recouvert d'isolant présenterait des valeurs de DIT trop élevées et donc de médiocres propriétés électriques, insuffisantes pour les applications visées.

Plusieurs exemples particuliers de réalisation vont maintenant être décrits.

Exemple 1 : réalisation d'un substrat de type SOI dont l'épaisseur d'oxyde est de 25 nm.

On a procédé à l'oxydation thermique d'un substrat en silicium, de 200 mm de diamètre, de façon à former sur celui-ci une couche d'isolant en oxyde de silicium ($SiO_2$), d'une épaisseur de 10 nm.

De façon similaire, on a procédé à la formation d'une couche d'oxyde de silicium de 15 nm sur un substrat source en silicium de même taille.

Ensuite, les deux substrats ont subi un traitement thermique de recuit de type "FGA", afin de parfaire les propriétés électriques des deux oxydes.

Le substrat source en silicium, a alors subi une étape d'implantation d'ions hydrogène, effectuée à travers la couche d'oxyde de silicium le recouvrant. Cette implantation a été effectuée à une dose de $5,5.10^{16}$ $H^+/cm^2$, selon une énergie d'implantation de 35 keV.

La surface supérieure de ce substrat a ensuite été nettoyée successivement avec une solution SC1, puis SC2.

La couche d'oxyde de silicium du substrat source ainsi préparée, a ensuite été soumise à un traitement d'activation par un plasma oxygène, appliqué pendant 30 secondes, avec une densité de puissance de $0.8W/cm^2$, à une pression d'oxygène de 50 mTorr (6,66 Pa), un flux de 75sccm (de l'anglais *"standard cubic centimeter"*, centimètre cube standard), à 20°C.

L'activation par plasma a modifié la nature de la couche d'oxyde sur une épaisseur maximale de 5,5 nm. On observe donc que l'épaisseur de l'oxyde qui est de 15 nm est nettement supérieure à l'épaisseur traitée par le plasma plus la distance tunnel **d** qui est de 2 nm. On respecte ainsi la relation mathématique précitée.

On a ensuite procédé au nettoyage des surfaces à mettre en contact par rinçage dans des bains chimiques et/ou brossage, puis au collage par adhésion moléculaire.

Enfin, on a réalisé un traitement thermique de quelques heures, à une température comprise entre 350 et 600° C, afin de séparer et détacher la partie arrière du substrat source de la couche active.

Après le détachement, on a procédé à la finition de surface du substrat SOI, (c'est-à-dire des étapes de stabilisation, amincissement et polissage).

Les valeurs de DIT au niveau des interfaces 311 et 321, avant le traitement de l'activation par plasma, étaient respectivement de l'ordre de quelques $10^{11}$ $.eV^{-1}.cm^{-2}$.

Le substrat composite final obtenu présente des valeurs de DIT du même ordre de grandeur, respectivement pour les interfaces 311 et 321.

Des résultats identiques ont été obtenus pour des substrats en silicium de 300 mm de diamètre, avec un flux de 150 sccm (de l'anglais *"standard cubic centimeter"*, centimètre cube standard)

Exemple 2 : réalisation d'un substrat de type SOI dont l'épaisseur d'oxyde est de 11 nm.

On procède comme dans l'exemple 1, avec respectivement des épaisseurs d'oxyde de 3 nm sur le substrat support et 10 nm sur le substrat source. On traite ensuite les oxydes ainsi obtenus à 450°C, pendant environ 1heure, dans une atmosphère formée de 2% d'hydrogène dans de l'argon (traitement FGA Forming gas anneal), de manière à améliorer les valeurs de DIT.

Le substrat source qui comporte la couche d'oxyde la plus épaisse est activé par plasma avec une puissance de $2W/cm^2$, ce qui conduit à modifier l'oxyde sur environ 7 nm.

Cette couche d'isolant traitée par plasma est nettoyée dans une solution de SC1, avec une concentration, une température et un temps suffisant pour la graver sur une profondeur de l'ordre de 2 nm.

On obtient comme substrat composite final, une structure de type SOI, qui comprend une couche enterrée d'isolant, d'une épaisseur de l'ordre de 11nm et qui présente de bonnes qualités électriques, en particulier un DIT de l'ordre de quelques $10^{10}.eV^{-1}.cm^{-2}$.

Exemple 3 : réalisation d'un substrat de type GeOI dont l'épaisseur d'oxyde est de 20 nm.

On forme une couche de 5 nm de $HfO_2$ sur un substrat source en germanium massif de 200 mm de diamètre. Selon une variante, le substrat source peut consister en une plaque de silicium de 200 mm, sur laquelle on a formé par épitaxie une couche de germanium.

On forme par ailleurs une couche d'oxyde de silicium ($SiO_2$) de 15 nm sur un substrat support en silicium (Si).

La couche d'oxyde de silicium du substrat support est ensuite soumise à un traitement d'activation par un plasma oxygène, appliqué pendant 30 secondes, avec une densité de puissance de $0.4W/cm^2$, à une pression d'oxygène de 50 mTorr (6,66 Pa), un flux de 75 sccm, à 20°C.

On procède ensuite au collage et au retrait de la partie supérieure du substrat source en germanium, par un détachement utilisant le procédé "Smart Cut™". On obtient un substrat GeOI avec une valeur de DIT de l'ordre de quelques $10^{11}$ $eV^{-1}.cm^{-2}$ à l'interface avec le germanium et de quelques $10^{10}$ $eV^{-1}.cm^{-2}$ à l'interface avec le silicium.

On notera que la valeur de DIT obtenue est plus élevée que dans les exemples précédents, parce qu'à ce jour, la préparation de surface du germanium (Ge), et le choix des isolants adaptés à ces matériaux ne sont pas bien maîtrisés. Il est possible qu'à l'avenir un choix plus judicieux des traitements de surface et des matériaux choisis comme isolants et leurs conditions de formation conduisent à des valeurs de DIT plus faibles. L'invention proposée ici permettra de s'adapter à cette évolution de la technique.

Exemple 4 : réalisation d'un substrat composite.

On procède comme dans l'exemple 3, si ce n'est que le substrat support n'est pas un substrat de silicium massif, mais un substrat hybride de type SOI. Il est formé lui même d'un substrat support en silicium, d'une couche isolante enterrée de $SiO_2$ de 150 nm, et d'une couche superficielle de silicium (Si) de 100 nm.

La couche superficielle de ce substrat support hybride est oxydée sur environ 10 nm, de façon à former un oxyde de silicium d'une épaisseur de l'ordre de 20 nm.

Ensuite on procède à l'activation plasma, au collage et retrait de la partie arrière du substrat source comme dans l'exemple précédent. On forme ainsi au final une structure composite comprenant successivement :

- le substrat support,
- un isolant d'oxyde de silicium de 150 nm,
- une couche de Si de 90 nm
- une couche d'oxyde de 20 nm,
- une couche de $HfO_2$ de 5 nm,
- la couche finale de Ge.

Exemple 5 : réalisation d'un substrat du type double SOI dont chacune des couches d'isolant enterré est mince.

On reproduit une première fois l'exemple 1, puis une seconde fois, en utilisant comme substrat support, le substrat SOI obtenu la première fois à la fin du procédé de l'exemple 1.

On obtient ainsi un substrat composite comprenant successivement :

- le substrat support,
- un isolant d'oxyde de silicium de 25 nm,
- une couche de Si de 50 nm
- une couche d'oxyde de silicium de 25 nm,
- une couche finale de silicium de 50 nm.

Les substrats composites obtenus conformément aux exemples 4 et 5 présentent de bonnes performances électriques à chacun de ses interfaces, même les plus profondes, ce qui ne pourrait pas être obtenu par un traitement final du type FGA.

**Revendications**

1. Procédé de fabrication d'un substrat composite (4), du type comprenant au moins une couche mince d'isolant (3), dite "couche finale", intercalée entre un premier substrat semi-conducteur (1), dit "substrat support" et une couche de matériau semi-conducteur (20), dite "couche active", **caractérisé en ce qu'**il comprend les étapes de :

- formation ou dépôt d'une couche d'isolant (31), dite "première couche", sur ledit substrat support (1) et d'une couche d'isolant (32), dite "seconde couche", sur un second substrat (2), dit "substrat source",

- activation par plasma d'au moins l'une desdites première (31) et seconde (32) couches d'isolant,
- collage dudit substrat support (1) et dudit substrat source (2) l'un contre l'autre, par adhésion moléculaire, de façon que lesdites première et seconde couches d'isolant (31, 32) soient en contact, le long d'une interface de collage (5), et forment ensemble ladite couche finale (3) d'isolant,
- retrait d'une partie (21), dite "arrière" du substrat source (2), de façon à ne conserver qu'une épaisseur de matériau constituant ladite couche active (20),

la valeur de l'énergie d'activation par plasma et les épaisseurs respectives ($e_1$, $e_2$) de la première et de la seconde couches d'isolant (31, 32) étant choisies, de façon que la couche d'isolant (31, 32) activée ne le soit que dans sa partie supérieure, s'étendant depuis sa surface libre (310, 320), et l'épaisseur de ladite couche finale d'isolant (3) est inférieure ou égale à 50 nanomètres (50 nm).

2. Procédé selon la revendication 1, **caractérisé en ce que** l'épaisseur ($e_1$) de la première couche d'isolant (31) formée ou déposée sur le substrat support (1) et l'épaisseur ($e_2$) de la seconde couche d'isolant (32) formée ou déposée sur le substrat source (2) satisfont aux relations suivantes :

$$e_1 \geq e_{mp1} + d_1 \quad \text{et} \quad e_2 \geq e_{mp2} + d_2$$

dans lesquelles $e_{mp1}$ et $e_{mp2}$ correspondent respectivement à l'épaisseur de la première couche d'isolant (31) et à l'épaisseur de la seconde couche d'isolant (32) dont la nature est modifiée après le traitement par activation par plasma et $d_1$ et $d_2$ correspondent aux distance s "tunnel" respectives de la première et de la seconde couches d'isolant.

3. Procédé selon la revendication 1 ou 2, **caractérisé en ce que** les première et seconde couches d'isolant (31, 32) ont des valeurs de densité de pièges d'interface (DIT) inférieures ou égales à $10^{11}$ .eV$^{-1}$.cm$^{-2}$, de préférence inférieures ou égales à quelques $10^{10}$.eV$^{-1}$.cm$^{-2}$, à leurs interfaces respectives (311, 321) avec les couches sur lesquelles elles sont déposées ou formées, lorsque ces dernières sont en silicium et que les couches d'isolant sont en dioxyde de silicium ($SiO_2$).

4. Procédé selon l'une des revendications précédentes, **caractérisé en ce que** la première couche d'isolant (31) ou/et la seconde couche d'isolant (32) est/sont un oxyde.

5. Procédé selon l'une des revendications précédentes, **caractérisé en ce que** la première couche d'isolant (31) ou/et la seconde couche d'isolant (32) est/sont un matériau diélectrique à forte permittivité.

6. Procédé selon la revendication 5, **caractérisé en ce que** le matériau diélectrique à forte permittivité est choisi parmi le groupe comprenant le dioxyde de hafnium ($HfO_2$), l'oxyde d'yttrium ($Y_2O_3$), le trioxyde de strontium et de titane ($SrTiO_3$), l'alumine ($Al_2O_3$), le dioxyde de zirconium ($ZrO_2$), le pentoxyde de tantale ($Ta_2O_5$), le dioxyde de titane ($TiO_2$), leurs nitrures et leurs siliciures.

7. Procédé selon la revendication 4, **caractérisé en ce que** la première (31) et/ou la seconde (32) couche (s) d'oxyde sont obtenues par oxydation thermique respectivement du substrat support (1) et/ou du substrat source (2).

8. Procédé selon l'une des revendications précédentes, **caractérisé en ce que** l'activation par plasma consiste à soumettre la première et/ou la seconde couche(s) d'isolant (31, 32) à un plasma oxygène avec un débit compris entre 50 et 200 sccm, une pression à l'intérieur de l'enceinte de 50 mTorr, une puissance de plasma d'environ 250 W pour des substrats de 200 mm et d'environ 500 W pour des substrats de 300 mm, pendant une durée comprise entre 5 et 60 secondes.

9. Procédé selon l'une des revendications précédentes, **caractérisé en ce qu'**il comprend en outre une étape de recuit sous un mélange de gaz neutre et d'hydrogène, à une température voisine de 900°C, pendant une durée d'au moins deux heures, d'au moins l'un des deux substrats (1, 2) recouvert de sa couche d'isolant (31, 32), cette étape étant réalisée avant l'activation par plasma.

10. Procédé selon l'une des revendications précédentes, **caractérisé en ce que** le retrait de la partie arrière (21) du substrat source (2) est effectué par meulage et/ou polissage.

11. Procédé selon l'une des revendications 1 à 9, **caractérisé en ce qu'**il comprend la formation d'une zone de fragilisation (22) à l'intérieur du substrat source (2), effectuée avant l'étape d'activation par plasma et le retrait de la partie arrière (21) du substrat source (2), par détachement le long de cette zone de fragilisation (22).

12. Procédé selon la revendication 11, **caractérisé en ce qu'**il consiste après la formation de la seconde couche d'isolant (32), à effectuer une étape d'implantation d'espèces atomiques à l'intérieur du substrat source (2), de façon à y définir ladite zone de fragilisation (22).

**13.** Procédé selon les revendications 9 et 12, **caractérisé en ce que** l'étape de recuit sous gaz neutre et sous hydrogène est réalisée avant l'étape d'implantation d'espèces atomiques.

**14.** Procédé selon une quelconque des revendications précédentes, **caractérisé en ce qu'**il comprend une étape d'amincissement d'au moins l'une des première et seconde couches d'isolant (31, 32), réalisée après l'activation par plasma et avant le collage.

**15.** Procédé de fabrication d'un substrat de type SOI, selon l'une quelconque des revendications précédentes, **caractérisé en ce que** le substrat source (2) est en silicium et la première et la seconde couches d'isolant (31, 32) en oxyde de silicium.

**16.** Procédé selon l'une quelconque des revendications précédentes, **caractérisé en ce que** l'épaisseur de ladite couche finale d'isolant (3) est inférieure ou égale à 20 nanomètres (20 nm).

**17.** Substrat composite (4), **caractérisé en ce qu'**il comprend au moins une couche d'isolant (31, 32), intercalée entre un premier substrat semi-conducteur (1), dit "substrat support" et une couche de matériau semi-conducteur (20), dite "couche active", cette ou ces couche (s) d'isolant (31, 32) formant une couche d'isolant (3) dite "finale" ayant une épaisseur totale inférieure ou égale à 50 nanomètres (50 nm), et présentant des valeurs de densité de pièges d'interface (DIT) inférieures ou égales à $10^{11}.eV^{-1}.cm^{-2}$ à son interface (311) avec ledit substrat support (1) et à son interface (321) avec ladite couche active (20).

**18.** Substrat composite selon la revendication 17, **caractérisé en ce que** la ou lesdites couches d'isolant (3, 31, 32) sont un oxyde.

**19.** Substrat composite selon la revendication 17 ou 18, **caractérisé en ce que** la ou lesdites couches d'isolant (3, 31, 32) sont un matériau diélectrique à forte permittivité.

**20.** Substrat composite selon l'une des revendications 17 à 19, **caractérisé en ce que** la couche active (20) est réalisée dans un matériau choisi parmi le silicium (Si), le germanium (Ge), le carbure de silicium (SiC), le nitrure de gallium (GaN) ou le silicium germanium (SiGe).

**21.** Substrat composite selon l'une des revendications 17 à 20, **caractérisé en ce que** l'épaisseur totale de ladite couche finale d'isolant (3) est inférieure ou égale à 20 nanomètres (20 nm).

**22.** Substrat composite selon l'une des revendications 17 à 21, **caractérisé en ce que** ladite couche finale d'isolant (3) présente des valeurs de densité de pièges d'interface (DIT) inférieures ou égales à quelques $10^{10}.eV^{-1}.cm^{-2}$.

## FIG. 1A

## FIG. 1B

## FIG. 1C

## FIG. 1D

## FIG. 1E

## FIG. 2A

## FIG. 2B

## FIG. 2C

## FIG. 2D

## FIG. 2E

## FIG. 3A

## FIG. 3B

## FIG. 3C

## FIG. 3D

## FIG. 3E

## FIG. 4

## FIG. 5

**Office européen**
**des brevets**

**RAPPORT DE RECHERCHE EUROPEENNE**

Numéro de la demande

EP 07 10 0879

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | EP 0 975 011 A (CANON KK [JP]) 26 janvier 2000 (2000-01-26)<br><br>* colonne 25, alinéa 213 - alinéa 217; figure 12 *<br>* colonne 24; exemple 5 *<br>----- | 1-4, 8-18, 20-22 | INV. H01L21/762 |
| Y | WO 03/103057 A (ADVANCED MICRO DEVICES INC [US]) 11 décembre 2003 (2003-12-11)<br><br>* page 4, ligne 30 - page 6, ligne 21; figures 1a-1e *<br>----- | 1-4, 8-18, 20-22 | |
| A | WO 2005/014895 A (SOITEC SILICON ON INSULATOR [FR]; FAURE BRUCE [FR]; DI CIOCCIO LEA [FR] 17 février 2005 (2005-02-17) * page 15, ligne 19 - ligne 21; figures 1-4 *<br>----- | 5-7,19 | |
| A | US 2002/137265 A1 (YAMAZAKI SHUNPEI [JP] ET AL) 26 septembre 2002 (2002-09-26) * page 6, alinéa 113 - alinéa 121; figures 2a-2e *<br>----- | 1,17 | **DOMAINES TECHNIQUES RECHERCHES (IPC)**<br><br>H01L |

Le présent rapport a été établi pour toutes les revendications

| Lieu de la recherche | Date d'achèvement de la recherche | Examinateur |
|---|---|---|
| La Haye | 21 mars 2007 | Hedouin, Mathias |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

...........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 07 10 0879

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-03-2007

| Document brevet cité au rapport de recherche | | Date de publication | Membre(s) de la famille de brevet(s) | | Date de publication |
|---|---|---|---|---|---|
| EP 0975011 | A | 26-01-2000 | CN | 1245971 A | 01-03-2000 |
| | | | TW | 444266 B | 01-07-2001 |
| | | | US | 6171932 B1 | 09-01-2001 |
| WO 03103057 | A | 11-12-2003 | AU | 2002360825 A1 | 19-12-2003 |
| WO 2005014895 | A | 17-02-2005 | CN | 1826434 A | 30-08-2006 |
| | | | EP | 1664396 A1 | 07-06-2006 |
| | | | FR | 2857982 A1 | 28-01-2005 |
| | | | JP | 2006528592 T | 21-12-2006 |
| | | | KR | 20060036472 A | 28-04-2006 |
| US 2002137265 | A1 | 26-09-2002 | AUCUN | | |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **K. SCHJÖLBERG-HENRIKSEN et al.** Oxide charges induced by plasma activation for wafer bonding. *Sensors and Actuators A,* 2002, vol. 102, 99-105
- **GREEN et al.** Ultrathin (<4nm) SiO2 and Si-O-N gate dielectric layers for silicon microelectronics: Understanding the processing, structure, and physical and electrical limits. *Journal of Applied Physics,* 01 Septembre 2001, vol. 90 (5), 2086

- Eltran® by splitting porous Si layers. **K. SAKAGUCHI ; P.L.HEMMENT et al.** PV99-3, Silicon-on-insulator technology and devices. Electro-Chemical Society, Inc, 117-121
- **C. MALEVILLE ; C. MAZURÉ.** Smart Cut™ technology: from 300 nm ultrathin SOI production to advanced engineered substrat es. *Solid-State Electronics,* 2004, vol. 48, 1055-1063